Europäisches Patentamt

(19) European Patent Office

Office européen des brevets

(11) Publication number: **0 181 073**
**B1**

(12) **EUROPEAN PATENT SPECIFICATION**

(45) Date of publication of patent specification: **06.09.89**

(21) Application number: **85306680.1**

(22) Date of filing: **19.09.85**

(51) Int. Cl.⁴: **C 23 C 10/28,** C 23 C 12/02, C 23 C 8/10, C 23 C 26/00, H 01 L 21/263

(54) **Method for controlling the injection and concentration of a supersaturation of exotic atoms deeply into a solid material.**

(30) Priority: **05.10.84 JP 208304/84**

(43) Date of publication of application:
**14.05.86 Bulletin 86/20**

(45) Publication of the grant of the patent:
**06.09.89 Bulletin 89/36**

(84) Designated Contracting States:
**DE FR GB**

(56) References cited:
**EP-A-0 046 914**
**EP-A-0 098 453**
**GB-A-1 194 049**
**GB-A-1 513 667**
**GB-A-2 073 254**
**GB-A-2 125 442**
**US-A-4 122 240**

(73) Proprietor: **OSAKA UNIVERSITY**
**1-1 Yamadaoka**
**Suita City Osaka-Fu (JP)**

(72) Inventor: **Mori, Hirotaro**
**52-D-404, Yamada-Nishi 3-Chome**
**Suita City Osaka-fu (JP)**
Inventor: **Fujita, Hiroshi**
**12-22 Yamatedai 5-Chome**
**Ibaraki City Osaka-Fu (JP)**

(74) Representative: **Rooney, Paul Blaise et al**
**D.Young & Co. 10 Staple Inn**
**London WC1V 7RD (GB)**

The file contains technical information
submitted after the application was filed and
not included in this specification

**Description**

This invention relates to a method of injecting foreign atoms into a solid matrix material.

Hitherto foreign atoms have been injected into selected positions in a solid metal sample, at concentrations of foreign atoms up to supersaturation, mainly by ion implantation. However in this known ion implantation method, the introduction of foreign atoms is limited to regions or positions just under the surface of the sample treated. Furthermore, severe irradiation damage is inevitably caused to the metal sample in the implantation regions and thus use of the ion implantation method is necessarily limited.

For example US—A—4122240 discloses a surface layer, thermal diffusion technique requiring the application to a substrate of a layer of material which forms a eutectic with the substrate, the melting of the layer into the substrate by laser or electron beam irradiation and the subsequent quenching of the molten layer to form a surface layer of substantially eutectic composition.

EP—A—0046914 discloses a further surface layer, thermal diffusion technique requiring the formation in a semi-conductor material of a disturbed surface layer by laser, the application to this disturbed surface layer of a metal layer and the alloying of this metal layer into the disturbed surface layer by melting the metal layer into the disturbed surface layer by heat supplied by a furnace, laser or electron beam.

According to the present invention there is provided a method of injecting foreign atoms into a solid matrix material using an electron beam, characterised by burying a foreign phase material, comprising at least one type of foreign atom to be injected, at at least one selected position in the matrix material to form a composite structure, irradiating the composite structure with an electron beam to displace the atoms of the foreign phase material into the matrix material and to displace the atoms of the matrix material into the foreign phase material so that the displaced atoms form at said at least one selected position a zone of atom mixture having a supersaturation concentration of said at least one type of foreign atom, wherein the energy of the electron beam utilised is in the range of from 1 to 10 MeV, the electron intensity is in the range from $10^{23}$ to $10^{25} e/m^2 \cdot s$, the irradiation time is in the range of from $10^3$ to $10^5$ seconds and the irradiation temperature is less than 173°K.

With this method, damage by irradiation is controlled to a negligible amount, and desired foreign atoms can be injected into the solid matrix material at selected positions deep in the solid matrix material at supersaturation concentrations.

In this invention the composite structure of matrix material and buried foreign phase material is made by vapor deposition, sintering, or clad rolling. It is preferable to use metals having a face-centered cubic lattice structure such as aluminium or gold as the matrix material. Also it is preferable to use atoms of germanium or silicon as the foreign phase material in the matrix of aluminium or gold.

For a better understanding of the present invention, reference will now be made by way of example, to the accompanying drawings, in which:

Figures 1a and 1b are schematic sectional views of different composite structures treated by the method of the invention, and

Figure 2 is a schematic view showing movement of atoms by electron beam irradiation in Figures 1a and 1b during treatment by the method of the invention.

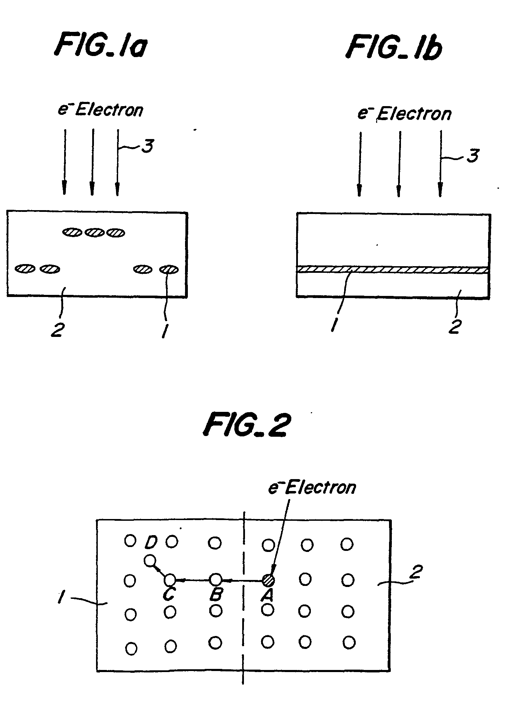

In Figures 1a and 1b, composite structures made up of solid matrix material 2 and a foreign phase material 1 containing the foreign atoms to be injected are illustrated. The foreign phase material 1 is buried in the matrix material 2 at different selected positions, for example in island form in Figure 1a and in layer form in Figure 1b. The composite structure 1, 2, is irradiated with an electron beam 3 which has sufficient energy to cause displacement of the foreign atoms which constitute the foreign phase material 1 and the atoms which constitute the matrix material 2. The irradiation is carried out at a low temperature sufficient to control thermal diffusion of the foreign atoms. By such irradiation, each foreign atom collides with electrons $e$ to jump randomly P times per second (regarding the electron energy as 2 MeV and the electron beam strength as $10^{24}$ $e/m^2 \cdot s$, P is about $10^{-2}$ to $10^{-3}/s$). As a result, the foreign atoms in the previously introduced foreign phase material 1 interdiffuse with the matrix material atoms, and each foreign phase material region connects with the surrounding matrix material so as to present a sloping concentration profile of foreign atoms. The concentration of the foreign atoms in the matrix material reaches supersaturation.

The concentration and distribution of the foreign atoms is controlled by the initial forms of the foreign phase ranges, and by the parameters of times of irradiation, temperature etc.

Electron irradiation for aluminium as the solid matrix material and for silicon as the foreign phase material, is carried out at irradiation levels of electron energy in the range of from 1 to 10 MeV, preferably in the range of from 2 to 5 MeV. The number P of collisions between electrons and atoms irradiated by the electron beams increases with increase of the electron energy. When the electron energy is greater than 10 MeV, it may cause nuclear transformation mutation of the material. When the electron energy is less than 1 MeV, the number P of collisions becomes too small, and as it takes a long time to produce the necessary change of concentration (or diffusion length), this is not preferred. The electron intensity is in the range of from $10^{23}$ to $10^{25} e/m^2 \cdot s$, preferably about $10^{24} e/m^2 \cdot s$. For an electron intensity of more than $10^{25} e/m^2 \cdot s$, it is difficult to make an electron gun. When the electron intensity is less than $10^{23} e/m^2 \cdot s$, the necessary irradi-

ation time increases too much to be useful. When the electron intensity is high, the irradiation time for the electron beam may be short. When the electron intensity is low, long irradiation times are required. The irradiation time is in the range of from about $10^3$ to $10^5$ seconds. The irradiation temperature is less than 173°K. When the irradiation temperatures are too high, thermal diffusion of atoms is induced to deposit the foreign atoms only. As these deposited atoms do not form a solid solution condition but only a segregation of deposit condition, such high temperatures are not preferred.

In order more fully to describe the present invention, the following example is given. This example shows suitable irradiation conditions to produce the injection of a supersaturated concentration of foreign atoms according to the method of the invention.

Example 1

Aluminium plates having a thickness of 3 μm were used as the solid matrix material, and small germanium plates having a thickness of 0.01 μm (100 Å) and a diameter of about 1 μm were used as the foreign phase material. The germanium plates were heat treated so as to become buried in each aluminium plate. The composite structure samples so obtained were irradiated with an electron beam having an electron energy of 2 MeV and an electron intensity of $10^{24}$ e/m² · s at an irradiation temperature of 93°K for $10^4$ seconds.

When the composite structure sample of crystalline metal was irradiated at a voltage which was accelerated over its threshold voltage (the value determined by the kind of material being treated, for example, the value of aluminium being about 160 kV), some atoms which constituted the crystals were knocked out from the crystal lattice points, and these displaced atoms moved to adjacent lattice points. This condition is illustrated in Figure 2. It is assumed that the foreign phase material 1 is made up of germanium atoms only, and the matrix material 2 is made up of aluminium atoms only. Atom A knocked out by the electron e- moves to the position of atom B, atom B moves to the position of atom C and atom C moves to the position of atom D. As a result, an aluminium atom enters into the germanium region. Of course, there are atoms which move from the foreign phase material 1 into the matrix material 2 in other places. Therefore, by the repetition of such movements, the interface or boundary between the foreign phase material 1 and the matrix material 2 gradually becomes indistinct.

When this state is observed directly using an electron microscope while the samples are irradiated with the electron beam, the little germanium plates become gradually smaller and then some of them disappear altogether. Finally, the deposited germanium re-forms a solid solution in the aluminium phase. In the intermediate state, the germanium plates are non-crystalline. It has been found that the germanium plates melt successively into crystalline deposits—non-crystalline deposits—reformation of solid solution.

When silicon plates are used instead of the germanium plates, similar results are obtained. Similar results are also obtained when the matrix is gold and the foreign phase material is germanium or silicon.

The effect of the method of this invention is as follows.

A) In the conventional ion implantation method, the introduction or injection of the foreign atoms was limited to a distance of several hundred angstroms deep at most under the surface of the matrix material. As the present invention uses electron beams having a particular great transmissivity as its irradiation source, it is possible to produce the injection of a supersaturation concentration of foreign atoms at selected positions in the matrix material to thicknesses and depths of several tens of μm.

B) Furthermore, if the form and distribution of the foreign phase material regions introduced are controlled during introduction, it is possible for form desired shapes of injected foreign atom regions, having a supersaturation concentration, in the matrix material, while it is difficult to form any shapes by the ion implantation method. For example, if foreign phase material regions having a thin platelike shape are made into one phase or multiple phases to introduce into the matrix material, or if the matrix material has therein foreign phase material regions of stick form extending general parallel to one another in the matrix material, in the general pattern of a draining board, materials containing regions of supersaturated concentration foreign atoms which have a one-dimensional or two-dimensional characteristic can be obtained.

C) In the method of this invention, since electron beams are used as the irradiating source, the shape and size of the foreign phases can be controlled by the electromagnetic field which is capable of greater precision than the ion implantation method. Thus, local supersaturated regions of foreign atoms with a diameter of several tens of angstroms can be precisely formed at selected positions in the matrix material.

D) In the conventional ion implantation method, the type of foreign atoms which are injected at a supersaturated concentration is usually limited to one type. However, in the method of this invention, the chemical components of the foreign phase materials which are buried in the matrix material can be freely chosen. Accordingly, multicomponent atoms can be injected into the matrix material at supersaturated concentrations at the same time as occasion demands at a fixed rate.

The method of this invention is useful in the production of:

(1) electron materials, amorphous materials and various composite materials, in which foreign atoms having any volume are injected into any three-dimensional matrix material,

(2) new materials containing more than two types of foreign atoms which are unexpected from the phase diagrams, and which can be produced with supersaturated concentrations of the foreign atoms in a three-dimensional state, and

(3) electron materials and various composite materials which have a gradual change of concentration across the interface between the foreign phase material and the matrix material.

## Claims

1. A method of injecting foreign atoms into a solid matrix material, characterised by burying a foreign phase material (1), comprising at least one type of foreign atom to be injected, at at least one selected position in the matrix material (2) to form a composite structure (1, 2), irradiating the composite structure (1, 2) with an electron beam (3) to displace the atoms of the foreign phase material (1) into the matrix material (2) and to displace the atoms of the matrix material (2) into the foreign phase material (1) so that the displaced atoms form at said at least one selected position a zone of atom mixture having a supersaturation concentration of said at least one type of foreign atom, wherein the energy of the electron beam utilised is in the range of from 1 to 10 MeV, the electron intensity is in the range of from $10^{23}$ to $10^{25}$ e/m² · s, the irradiation time is in the range of from $10^3$ to $10^5$ seconds and the irradiation temperature is less than 173°K.

2. A method according to claim 1, in which the foreign phase material (1) consists of atoms of germanium or silicon.

3. A method according to claim 1 or claim 2, in which the matrix material (2) is aluminium or gold.

## Patentansprüche

1. Verfahren zur Einführung von Fremdatomen in ein festes Matrixmaterial, dadurch gekennzeichnet, daß man ein Fremdphasenmaterial (1), das wenigstens eine einzuführende Fremdatomtype umfaßt, an wenigstens einer ausgewählten Position in dem Matrixmaterial (2) unter Bildung einer zusammengesetzten Struktur (1, 2) einführt, die zusammengesetzte Struktur (1, 2) mit einem Elektronenstrahl (3) bestrahlt und so die Atome des Fremdphasenmaterials (1) in das Matrixmaterial (2) verschiebt und die Atome des Matrixmaterials (2) in das Fremdphasenmaterial (1) verschiebt, so daß die verschobenen Atome in der wenigstens einen ausgewählten Position eine Atomgemischzone mit einer Übersättigungskonzentration der wenigstens einen Fremdatomtype bilden, wobei die Energie des benutzten Elektronenstrahls im Bereich von 1 bis 10 MeV liegt, die Elektronenintensität im Bereich von $10^{23}$ bis $20^{25}$ e/m² · s ist, die Bestrahlungszeit im Bereich von $10^3$ bis $10^5$ sec liegt und die Bestrahlungstemperatur geringer als 173°K ist.

2. Verfahren nach Anspruch 1, bei welchem das Fremdphasenmaterial (1) aus Germanium- oder Siliciumatomen besteht.

3. Verfahren nach Anspruch 1 oder Anspruch 2, bei dem das Matrixmaterial (2) Aluminium oder Gold ist.

## Revendications

1. Procédé d'injection d'atomes étrangers dans un matériau de matrice solide, caractérisé en ce qu'on enfouit un matériau de phase étrangère (1), comportant au moins un type d'atome étranger à injecter, en au moins un emplacement choisi du matériau de matrice (2) pour former une structure composite (1, 2), on irradie la structure composite (1, 2) au faisceau électronique (3) pour faire passer les atomes du matériau de phase étrangère (1) dans le matériau de matrice (2) et pour faire passer les atomes du matériau de matrice (2) dans le matériau de phase étrangère (1) de façon que les atomes déplacés forment à l'emplacement ou à chaque emplacement choisi une zone de mélange d'atomes ayant une concentration de sursaturation en atomes étrangers du ou de chaque susdit type, où l'énergie du faisceau électronique utilisé est comprise entre 1 et 10 MeV, l'intensité électronique est comprise entre $10^{23}$ et $10^{25}$ e/m² · s, le temps d'irradiation cet compris entre $10^3$ et $10^5$ secondes et la température d'irradiation est inférieure à 173°K.

2. Méthode selon la revendication 1, dans laquelle le matériau de phase étrangère (1) est constitué par des atomes de germanium ou de silicium.

3. Procédé selon la revendication 1 ou la revendication 2, dans lequel le matériau de matrice (2) est de l'aluminium ou de l'or.

# FIG. 1a

e⁻ Electron

# FIG. 1b

e⁻ Electron

# FIG. 2

e⁻ Electron